# EUROPEAN PATENT APPLICATION

(11) **EP 4 810 675 A1**
(43) Date of publication of application: **23.09.2026**
(21) Application number: 25165258.2
(22) Date of filing: 21.03.2025
(51) Int. Cl.: C30B 23/00, C30B 23/02, C30B 29/36

(54) **PRODUCTION METHOD FOR A SIC VOLUME MONOCRYSTAL AND SIC SOURCE MATERIAL TO BE USED IN SUCH A PRODUCTION METHOD**

(71) Applicant: SiCrystal GmbH, 90411 Nürnberg (DE)
(72) Inventor: Müller, Ralf, 90411 Nürnberg (DE); Hosomi, Tadahiro, 90411 Nürnberg (DE); Eckstein, Robert, 90411 Nürnberg (DE); Schuh, Philipp, 90411 Nürnberg (DE)
(74) Representative: Rau, Schneck & Hübner Patentanwälte Rechtsanwälte PartGmbB

(57) **Abstract**

The method is intended for the production of at least one SiC volume monocrystal (2) by sublimation growth. Prior to the start of growth, at least one SiC seed crystal (8) is arranged in a crystal growth region (5) of a growing crucible (3), and SiC source material (6) is provided and inserted into a SiC storage region (4) of the growing crucible (3). During the growth by means of sublimation of the SiC source material (6) and by means of transport of the sublimated gaseous components into the crystal growth region (5), a SiC growth gas phase (9) is produced in the crystal growth region (5), in which a SiC volume monocrystal (2) grows on the SiC seed crystal (8) by means of deposition from the SiC growth gas phase (9). A ratio of carbon atoms to silicon atoms in the provided SiC source material (6) is at least 1.01:1, in particular at least 1.05:1.

## Description

The invention relates to a method for the production of at least one SiC volume monocrystal by means of sublimation growth and to a SiC source material to be used in such a production method.

Due to its outstanding physical, chemical, electrical and optical properties, the semiconductor material silicon carbide (SiC) is used, among others, as a starting material for power electronic semiconductor components, for high-frequency components and for special light-emitting semiconductor components. For these components, SiC substrates (= SiC wafers) with the largest possible substrate diameter and the highest possible quality are required.

The basis for the SiC substrates are high-grade SiC volume monocrystals, which are usually produced by means of physical vapor deposition treatment (PVT), in particular by means of a (sublimation) method described, for example, in US 8,865,324 B2. In this growth method, a monocrystalline SiC disc is introduced into a growing crucible as a SiC seed crystal together with suitable source material. Under controlled temperature and pressure conditions, the source material is sublimed and the gaseous species deposit on the SiC seed crystal so that the SiC volume monocrystal grows there.

Disc-shaped monocrystalline SiC substrates are then cut out of the SiC volume monocrystal, e.g. with the help of a thread saw, and after a multi-stage refining treatment of their surface, in particular by means of several polishing steps, they are provided with at least one thin monocrystalline epitaxial layer, for example of SiC or GaN (gallium nitride), as part of the component manufacturing process. The properties of this epitaxial layer and thus ultimately those of the components produced therefrom depend decisively on the quality of the SiC substrate or the underlying SiC volume monocrystal. Therefore, it is of utmost importance to have reliable control over the growth conditions during the crystal growth.

There have been attempts to influence the growth process by tailoring the properties of the source material. For example, US 2023/0193508 A1 describes a powder-like source material, which comprises a specific doping concentration of nitrogen or ammonia to adjust the resistivity of the grown single crystalline material. RU 20 945 47 C1 describes using a sintered ceramic as source material, which is created by re-sublimation processes preliminary to the SiC crystal growth.

It is an object of the present invention to provide an improved method for the production of a SiC volume monocrystal compared to known solutions, in particular to provide a method, which allows for a flexible and precise control over the growth conditions during the crystal growth.

This object is achieved by a method with the features of claim 1. The method according to the invention is a method for the production of at least one SiC volume monocrystal by means of sublimation growth, wherein, prior to start of growth, at least one SiC seed crystal is arranged in the crystal growth region of a growing crucible, and SiC source material is provided and inserted into a SiC storage region of the growing crucible. During the growth by means of sublimation of SiC source material and by means of transport of the sublimated gaseous components into the crystal growth region, a SiC growth gas phase is produced in the crystal growth region, in which a SiC volume monocrystal growth on the SiC seed crystal, in particular on a growth surface (also referred to as growth interface) thereof, by means of deposition from the SiC growth gas phase. In the provided SiC source material, a ratio of carbon atoms to silicon atoms is at least 1.01:1, in particular at least 1.05:1. The ratio of carbon atoms to silicon atoms may be at least 1.1:1, preferably at least 1.2:1.

The provided SiC source material, which is inserted into the SiC storage region, has a carbon content, which exceeds the stoichiometric ratio of SiC. The stoichiometric ratio of SiC corresponds to a ratio of carbon atoms to silicon atoms of 1:1. In other words, the SiC source material has an excessive carbon content.

The excessive carbon content may also be quantified by means of atomic percent (at%). The carbon content of the provided SiC source material exceeds, in relation to the silicon content, the stoichiometric ratio of SiC by at least 1 at%, in particular by at least 5 at%, in particular by at least 10 at%, preferably by at least 20 at%. In that case, the atomic percent is defined for the carbon content exceeding the stoichiometric ratio in relation to the silicon atoms in the provided SiC source material, in particular: $eC at % = \left(No\left(C\right)-No\left(Si\right)\right) / No \left(Si\right) ,$ wherein No(X) is the number of atoms of species X and eC refers to the excessive carbon content.

The inventors have realized that during the initial stages of the sublimation process, in particular during heating up the growing crucible up to the growth temperature, diffusion channels are formed in the SiC source material. The diffusion channels provide diffusion paths for gas species being transported from the bulk of the SiC source material into the SiC growth gas phase. As such, the formation of diffusion channels in the SiC source material influences the composition of the SiC growth gas phase. In particular, it has been found that, for a stoichiometric SiC powder, the number of diffusion channels and, thus, the transport of gas species essentially depends on the density of the powder. Hence, the composition of the SiC growth gas phase at a given growth temperature depends on the density of the stoichiometric powder. At the same time, the growth temperature and a temperature gradient between the SiC source material and the crystal growth region determine the material transport of the gas species to and within the SiC growth gas phase. Thus, in a stoichiometric SiC powder it is not possible to control the volume of sublimated gas species, their transport and their composition independently.

The inventors have found that the excessive carbon content allows tailoring the formation as well as the permeability of diffusion channels. In particular, the excessive carbon content tends to agglomerate the SiC source material, in particular by forming carbon agglomerates. Agglomerations within the SiC source material limit the formation of the diffusion channels. Moreover, the excessive carbon content, in particular carbon agglomerates can at least partially close diffusion channels. Thereby, the transport of gas species from the bulk powder can be controlled, in particular decreased.

Advantageously, the excessive carbon content provides a further parameter to control the growth condition. In particular, it is possible to separate the temperature and temperature gradient inside the growth crucible from the transport and composition of the SiC growth gas phase. The excessive carbon content enables a wider range of possible growth conditions. Particularly advantageously, the SiC growth gas phase can be influenced to meet best the optimal growth conditions for crystal growth. Thus, the formation of defects is strongly suppressed, which leads to a highly improved crystal quality.

The SiC source material having an excessive carbon content has the advantage that the growth condition can be further influenced without impeding the purity of the SiC source material and the crystal to be grown. The excessive carbon content can in particular act as an agglomeration agent with requiring the addition of other chemical elements, which may affect the crystal growth and/or which may have to be removed by complex procedures.

The method according to the invention can be used to produce a single SiC volume monocrystal, but also a larger number, for example two, three, four, five or also preferably up to ten SiC volume monocrystals. A method in which two SiC volume monocrystals are grown, in particular arranged one above the other or one behind the other in the direction of the central longitudinal axis, which grow on both sides of the SiC storage region as viewed in the direction of the central longitudinal axis, is favorable.

Providing the SiC source material may comprise, as part of the method, preparing the SiC source material. For example, providing the SiC source material may comprise synthesizing the SiC source material and/or other preparation steps, such as adding carbon-containing additives. Advantageous embodiments of the method according to the invention result from the features of the claims depending on claim 1.

According to a favorable embodiment, the ratio of carbon atoms to silicon atoms in the provided SiC source material is 1.5:1 or less, in particular 1.4:1 or less, preferably 1.3:1 or less. Particular suitable ratios of carbon atoms to silicon atoms range from 1.01:1 to 1.5:1, in particular from 1.05:1 to 1.4:1, preferably from 1.2:1 to 1.3:1. The respective amount of excessive carbon content has proven to be particularly advantageous for influencing the growth conditions in a targeted manner.

The excessive carbon content in relation to the silicon content, may be 50 at% or less, in particular 40 at% or less, preferably 30 at% or less. The excessive carbon content in relation to the silicon content may be from 1 at% to 50 at%, in particular from 5 at% to 30 at%, preferably from 20 at% to 30 at%.

According to a further favorable embodiment, the provided SiC source material has a density between 1 g/cm³ and 2.5 g/cm³, in particular between 1.2 g/cm³ and 1.9 g/cm³, preferably between 1.5 g/cm³ and 1.8 g/cm³. These densities have proven to be particularly suitable for favorable growth conditions, in particular in connection with the above-specified preferred ranges of the excessive carbon content. For example, the density may be measured as bulk density and/or tap density. For example, the density may be a tap density, in particular similar to or corresponding to the definition in DIN ISO 787-11: 1995-10.

According to a further favorable embodiment, the provided SiC source material comprises, in particular consists of a SiC powder and a carbon-containing additive. For example, providing the SiC source material may comprise mixing the SiC powder with one or more carbon-containing additives. The carbon-containing additive acts as a source for excess carbon in the SiC source material. The excessive carbon content can be added easily and flexibly via the carbon-containing additive. In particular, the amount of excessive carbon, its distribution within the SiC source material and/or its, in particular chemical, behavior can be precisely tailored.

The carbon-containing additive comprises or consists of carbon. It may comprise further elements or constituents. Preferably, further constituents of the carbon-containing additive may be volatile, in particular volatile elements or molecules, such as hydrogen atoms and/or molecules, oxygen atoms and/or molecules, water molecules and the like. Using volatile constituents allows for an easy removal of those further constituents, either in situ during the growth process or during a preparation process as part of providing the SiC source material.

The SiC powder may comprise a stoichiometric ratio of carbon to silicon atoms, i.e. a ratio of carbon atoms to silicon atoms being 1:1. In other words, the SiC powder may purely consist of SiC particles with a stoichiometric ratio of atoms. In this case, the excessive carbon content can be introduced in the SiC source material exclusively by one or more carbon-containing additives. A SiC powder comprising a stoichiometric ratio of carbon atoms to silicon atoms is also referred to as stoichiometric SiC powder in the following.

Additionally or alternatively, it is possible that the SiC powder itself comprises an excessive carbon content, in particular a carbon content exceeding the stoichiometric ratio of SiC. In that regard, the excess of carbon content of the SiC source material may result from the excessive carbon content of the SiC powder and the added one or more carbon-containing additives. A SiC powder, which comprises an excessive carbon content, is also referred to a non-stoichiometric SiC powder in the following.

The SiC powder, in particular a stoichiometric SiC powder, may be obtained by mixing silicon powder particles and carbon powder particles, in particular in the stoichiometric ratio of SiC (1:1), and reacting the resulting powder mixture in a reaction oven to obtain SiC powder. For example, a reaction temperature for reacting the silicon powder and carbon powder mixture may be at least 1,400 C°. In case, a non-stoichiometric SiC powder is to be obtained, the silicon powder particles and carbon powder particles may be mixed in a ratio to achieve the desired ratio of carbon atoms to silicon atoms. Provision of the SiC source material may comprise obtaining the SiC powder by the synthesis process. In the alternative, a pre-prepared SiC powder, in particular a stoichiometric SiC powder, may be used.

The carbon-based additive may be added after synthesis of the SiC powder. It is also possible to add the couple-based additive prior to synthesis process.

According to a further favorable embodiment, the carbon-containing additive comprises carbon particles and/or one or more carbon compounds.

Suitable carbon particles may have crystalline or amorphous structure. The carbon particles are in particular natural or synthesized graphite particles and/or black amorphous carbon particles. Using carbon particles has the particular advantage that the introduction of further constituents or elements is avoided.

Suitable carbon compounds may be any chemical compound comprising carbon, e.g. organic molecules. Carbon compounds may comprise long-chained carbon molecules. In particular, further constituents of the carbon compounds are volatile constituents. Preferably, the carbon compound may be chosen with regard to its dispersion properties in a SiC powder and/or to its reactive properties, in particular with regard to achieving a desired agglomeration of the SiC powder.

According to a further favorable embodiment, the carbon-containing additive comprises a carbon compound being a carbon glue and/or a carbohydrate, in particular a sugar. The carbon-containing additive comprising the carbon compound may consist of the carbon compound. For example, the carbon compound may be provided in pure form, for example in dry and/or powdered form. It is also possible that the carbon-containing additive comprises the carbon compound in form of a solution or dispersion, in particular an aqueous solution or dispersion.

Carbohydrates have proven to be particularly suitable carbon compounds. Carbohydrates have a large amount of carbon atoms and small amounts of further volatile constituents, namely oxygen and hydrogen. Preferred carbohydrates are any kind of sugar. For example, the carbohydrate may be a sugar being a monosaccharide or a disaccharide. For example, the carbon-containing additive may comprise, in particular may consist of, an aqueous carbohydrate solution, in particular an aqueous sugar solution.

Carbon glues have been proven particularly suitable with regard to their agglomeration properties. A carbon glue may be any adhesive mainly containing carbon atoms, for example being based on cyanoacrylate and/or one or more phenolic resins, for example one or more novolaks.

According to a further favorable embodiment, providing the SiC source material comprises mixing silicon powder particles with carbon powder particles to obtain a powdered raw material, wherein the carbon content in the powdered raw material exceeds the stoichiometric ratio of SiC, in particular in that a ratio of carbon atoms to silicon atoms is at least 1.01:1, and reacting the powdered raw material in a reaction oven to synthesize non-stoichiometric SiC source material. Advantageously, the excessive carbon content may be introduced already at the stage of synthesizing the SiC source material.

The synthesized SiC source material may be a powdered SiC source material, in particular the non-stoichiometric SiC powder described above. It is also possible that the obtained non-stoichiometric SiC source material is in form of a powder compact. The synthesis process may comprise an agglomeration process for agglomerating access carbon atoms, which have not reacted with silicon atoms to form SiC particles. For example, the excessive carbon content may agglomerate during the synthesis process to form a compacted SiC source material. Such a compacted SiC source material is also referred to as SiC source material body in the following.

In particular, the non-stoichiometric SiC source material comprises SiC particles and excess carbon. The excess carbon may be in the form of carbon particles and/or carbon agglomerates.

The synthesized non-stoichiometric SiC source material may be inserted into the SiC storage region. In that case, the amount of excess carbon in the powdered raw material may be chosen to achieve the desired ratio of carbon atoms to silicon atoms, in particular with a ratio of at least 1.01:1, in particular at least 1.05:1, in particular at least 1.1:1, in particular at least 1.2:1, preferably within one of the above-described ranges. It is also possible that the non-stoichiometric SiC source material, in particular in powdered form, is supplemented by a carbon-containing additive after the synthesis process and prior to inserting the SiC source material into the SiC storage region.

In the synthesis process, reaction temperatures between 1,000 °C and 2,500 °C, in particular between1,100 °C and 2,100 °C, preferably between 1,200 °C and 2,000 °C, may be used.

According to a further favorable embodiment, the SiC source material is inserted in powdered form into the SiC storage region, wherein a carbon content of the SiC source material, which exceeds the stoichiometric ratio of SiC, forms carbon agglomerates during heating up the crucible before growth starts. Advantageously, the agglomeration of the SiC source material can be obtained in situ in the growing crucible. Inserting the SiC source material in powdered form allows for precise dosing of the SiC source material. Particularly preferable, the excessive carbon content may be realized by synthesizing a non-stoichiometric SiC powder and/or by adding carbon particles. This way, the introduction of further elements into the growth process is inhibited.

According to a further favorable embodiment, providing the SiC source material comprises forming a SiC source material body, which contains carbon agglomerates and which is inserted into the SiC storage region. Forming the SiC source material body being powder compact prior to inserting the SiC source material into the SiC storage region, has the particular advantage that the agglomeration of the excessive carbon content can be precisely controlled. The properties of the SiC source material and with that of the growth condition, can be particularly flexibly and precisely tailored. Moreover, forming the SiC source material body can be used to remove any further constituents from the SiC source material, which may be added as part of a carbon-containing additive.

Forming the SiC source material body may comprise an agglomeration process and/or a sinter process. For example, formation of the SiC source material body may be after or during a synthesis process for obtaining SiC particles. For example, a SiC powder may be provided and/or synthesized. The SiC powder may be supplemented by one or more carbon-containing additives to obtain a SiC powder having an excessive carbon content. The SiC powder with excessive carbon content may then undergo an agglomeration and/or sinter process to form the SiC source material body. It is also possible to include the agglomeration process into a synthesis process of non-stoichiometric SiC source material, e.g. by choosing adequate synthesis conditions, in particular reaction temperatures.

According to a further favorable embodiment, forming the SiC source material body comprises mixing a, in particular stoichiometric, SiC powder with a carbon-containing additive to obtain a powder mixture and performing an agglomeration process on the powder mixture. This allows for a particularly precise and flexible control of the excessive carbon content. Further constituents of the carbon-containing additive, in particular hydrogen, oxygen and/or water molecules, may be removed during the agglomeration process.

According to a further favorable embodiment, the agglomeration process includes a temperature treatment of the powder mixture at an agglomeration temperature between 100 °C and 2,500 °C, in particular between 100 °C and 1,000 °C, in particular between 150 °C and 700 °C, preferably between 200 °C and 600 °C. The temperature treatment is particularly suitable for agglomerating the excessive carbon content and/or removing further constituents from the powdered mixture.

According to a further favorable embodiment, the agglomeration process includes a pressure treatment of the powder mixture, in particular at an agglomeration pressure between 3 bar and 200 bar, in particular between 10 bar and 150 bar. For example, a mechanical pressure may be exerted on the powder mixture, e.g. with a mechanical press.

In particular, the agglomeration process may comprise a temperature treatment and/or a pressure treatment. For example, a temperature treatment and a pressure treatment may be combined. For example, a temperature treatment and a pressure treatment may be performed either simultaneously or successively. In particular, a pressure treatment may be performed to obtain the pre-agglomerated powder mixture, on which a temperature treatment is performed.

It is a further object of the invention to improve a SiC source material to be used in production of a SiC volume monocrystal, in particular to provide a SiC source material, which allows for a better control of the growth condition.

This object is achieved by a SiC source material having the features outlined in claim 13. The SiC source material according to the invention comprises a ratio of carbon atoms to silicon atoms of at least 1.01:1, in particular at least 1.05:1, in particular at least 1.1:1, preferably at least 1.2:1. The advantages of the SiC source material coincide with those discussed in relation to the method above. The SiC source material may comprise one or more of the preferred features of the SiC source material discussed with regard to the method above. The SiC source material may be obtained in a preparation process as discussed above.

Particularly advantageous embodiments of the SiC source material result from the features of the claims depending on claim 13.

In a favorable embodiment, the SiC source material comprises, in particular consists of, a SiC powder and a carbon-containing additive. The SiC powder may be a stoichiometric or non-stoichiometric SiC powder. The carbon-containing additive may be any carbon-containing additive as discussed above.

According to a further favorable embodiment, the SiC source material is in form of a SiC source material body comprising carbon agglomerates. The SiC source material body may be obtained during a synthesis process of the SiC source material. It is also possible to obtain the SiC source material body by an agglomeration process performed on a powder mixture of SiC powder and a carbon-containing additive.

Further features, advantages and details of the invention will be apparent from the following description of embodiment examples based on the drawing, in which:
- Fig. 1: shows schematically an embodiment example of a growth arrangement for sublimation growth of a SiC volume monocrystal,
- Fig. 2: shows schematically the number of diffusion channels forming during growth in a stoichiometric SiC powder having a stoichiometric ratio of silicon and carbon atoms as a function of the density of the powder,
- Fig. 3A to 3C: shows schematically the formation of diffusion channels in the stoichiometric SiC powder,
- Fig. 4: shows schematically a detail of the stoichiometric SiC powder,
- Fig. 5: shows schematically a detailed view of SiC source material having a carbon content exceeding the stoichiometric ratio of SiC, and
- Fig. 6A to 6C: shows schematically different preparation methods for preparing the SiC source material of Fig. 5.

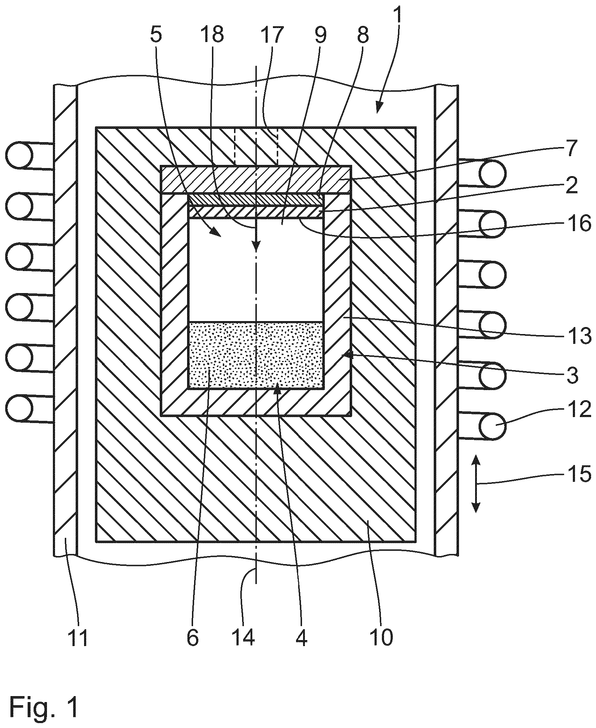

Parts that are corresponding to each other are marked with the same reference signs in Figs. 1 to 9. Details of the embodiment examples described in more detail below may also constitute an invention in their own right or form part of a subject matter of an invention.

Fig. 1 shows an embodiment example of a growth arrangement 1 for the production of a SiC volume monocrystal 2 by means of sublimation growth. The growth arrangement 1 contains a growing crucible 3, which comprises a SiC storage region 4 and a crystal growth region 5. The SiC storage region 4 contains SiC source material 6, which is inserted into the SiC storage region 4 of the growing crucible 3 as a prefabricated starting material before the start of the growth process. The SiC source material 6 may be in powdered or in a semi-compact or compact form. For example, it may be a powder or a powder compact.

In the region of a crucible end wall 7 of the growing crucible 3 opposite the SiC storage region 4, a SiC seed crystal 8 extending axially into the crystal growth region 5 is attached. The SiC seed crystal 8 is in particular monocrystalline. In the embodiment example shown, the crucible end wall 7 is formed as the crucible lid of the growing crucible 3. However, this is not mandatory.

The SiC volume monocrystal 2 to be grown grows on the SiC seed crystal 8 by means of deposition from a SiC growth gas phase 9 forming in the crystal growth region 5. The growing SiC volume monocrystal 2 and the SiC seed crystal 8 have approximately the same diameter. If at all, there is a deviation of at most 10% by which a seed diameter of the SiC seed crystal 8 is smaller than a monocrystal diameter of the SiC volume monocrystal 2. However, a gap not shown in Fig. 1 may be present between the inner side of a crucible sidewall 13 on the one hand and the growing SiC volume monocrystal 2 and the SiC seed crystal 8 on the other hand.

In the embodiment example according to Fig. 1, the growing crucible 3 including the crucible lid 7 consists of an electrically and thermally conductive graphite crucible material with a density of, for example, at least 1.75 g/cm³. A thermal insulation layer 10 is arranged around it. The latter consists, for example, of a foam-like graphite insulation material whose porosity is in particular significantly higher than that of the graphite crucible material.

The thermally insulated growing crucible 3 is placed inside a tubular container 11, which in the embodiment example is designed as a quartz glass tube and forms an autoclave or reactor.

For heating the growing crucible 3, an inductive heating device in the form of a heating coil 12 is arranged around the container 11. The growing crucible 3 is heated to the temperatures required for growth by means of the heating coil 12. In the embodiment example shown, these growth temperatures are at least 2,250°C. The heating coil 12 inductively couples an electric current into the electrically conductive crucible sidewall 13 of the growing crucible 3. This electric current flows substantially as a circular current in the circumferential direction within the circular and hollow cylindrical crucible sidewall 13, thereby heating the growing crucible 3. If needed, the relative position between the heating coil 12 and the growing crucible 3 can be changed axially, i.e. in the direction of a central longitudinal axis 14 of the growing SiC volume monocrystal 2, in particular in order to adjust and, if necessary, also change the temperature or the temperature profile within the growing crucible 3. The axially variable position of the heating coil 12 during the growth process is indicated in Fig. 1 by the double arrow 15. In particular, the heating coil 12 is displaced in accordance with the growth progress of the growing SiC volume monocrystal 2. The displacement preferably takes place downwards, i.e. in the direction of the SiC source material 6, and preferably by the same length by which the SiC volume monocrystal 2 grows, e.g. by a total of approximately 20 mm. For this purpose, the growth arrangement 1 comprises correspondingly designed monitoring-, control and adjustment means not shown in more detail.

The SiC growth gas phase 9 in the crystal growth region 5 is fed by the SiC source material 6. The SiC growth gas phase 9 contains at least gas components in the form of Si, Si₂C and SiC₂ (= SiC gas species). The material transport from the SiC source material 6 to a growth interface 16 at the growing SiC volume monocrystal 2 takes place on the one hand along an axial temperature gradient. In the sublimation method (= PVT method) used for SiC crystal growth, the growth conditions including the material transport are adjusted and controlled via the temperatures prevailing in the growing crucible 3. At the growth interface 16 there is a relatively high growth temperature of at least 2,250°C, in particular even of at least 2,350°C or 2,400°C°. Furthermore, an axial temperature gradient of at least 5 K/cm, preferably of at least 15 K/cm, measured in the direction of the central longitudinal axis 14, is set at the growth interface 16 in particular. The temperature within the growing crucible 3 decreases towards the growing SiC volume monocrystal 2. The highest temperature of approximately 2,450°C to 2,550°C prevails in the region of the SiC storage region 4. This temperature profile with a temperature difference of in particular 100°C to 150°C between the SiC storage region 4 and the growth interface 16 can be achieved by various measures. For example, axially varying heating can be provided by dividing the heating coil 12 into two or more axial sections, which is not shown in more detail. Furthermore, a stronger heating effect can be set in the lower section of the growing crucible 3 than in the upper section of the growing crucible 3, e.g. by a corresponding axial positioning of the heating coil 12. Moreover, the thermal insulation can be designed differently at the two axial crucible end walls. As schematically indicated in Fig. 1, the thermal insulation layer 10 can have a greater thickness at the lower crucible end wall than at the upper crucible end wall. Furthermore, it is possible that the thermal insulation layer 10 has a central cooling opening 17 arranged around the central longitudinal axis 14 adjacent to the upper crucible end wall 7, through which cooling opening 17 heat is dissipated. This central cooling opening 17 is indicated by the dashed lines in Fig. 1.

In addition, a growth pressure of in particular 0.1 hPa (= mbar) to 10 hPa (= mbar) prevails in the growing crucible 3 during the actual crystal growth.

The SiC volume monocrystal 2 grows in a growth direction 18, which in the embodiment example shown in Fig. 1 is oriented from top to bottom, i.e. from the crucible lid 7 towards the SiC storage region 4. The growth direction 18 runs parallel to the centrally arranged central longitudinal axis 14. Since the growing SiC volume monocrystal 2 is arranged concentrically within the growth arrangement 1 in the embodiment example shown, the centrally arranged central longitudinal axis 14 can also be assigned to the growth arrangement 1 as a whole.

The growing SiC volume monocrystal 2 has a SiC crystal structure of the 4H polytype. In principle, however, another polytype (= another crystal modification), such as 6H-SiC, 3C-SiC or 15R-SiC, is also possible. Advantageously, the SiC volume monocrystal 2 has only one SiC polytype, which in the embodiment example is said 4H-SiC. The SiC volume monocrystal 2 grows with a high modification stability and in this respect has essentially only one single polytype. The latter fact is favorable with regard to a very low-defect, high crystal quality.

During the initial stages of the sublimation process, in particular during heating up the growing crucible 3 up to the growth temperature, diffusion channels are formed in the SiC source material 6. The diffusion channels provide diffusion paths for gas species being transported from the bulk of the SiC source material 6 into the SiC growth gas phase 9. As such, the formation of diffusion channels, in particular their number, in the SiC source material influences the composition of the SiC growth gas phase 9 and, therefore, the growing conditions within the crystal growth region 5.

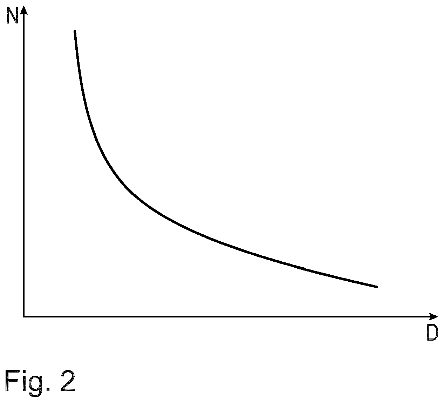

In general, the formation of the diffusion channels is governed by evaporation and sintering properties of the SiC source material 6, in particular its grain size distribution and density. In the following, this is illustrated for a SiC powder, in which silicon and carbon atoms are present in the stoichiometric ratio of SiC (i.e. in a ratio of 1:1). Such a stoichiometric SiC powder is discussed with respect to fig. 2 to 4.

In case of a stoichiometric SiC powder, the density of the powder, for example its bulk density or tap density, governs the formation of diffusion channels. In fig. 2, the general relationship of number of diffusion channels N with regard to the density D of the SiC powder is schematically shown. As can be seen, the number of diffusion channels N decreases with the density D of the stoichiometric SiC powder.

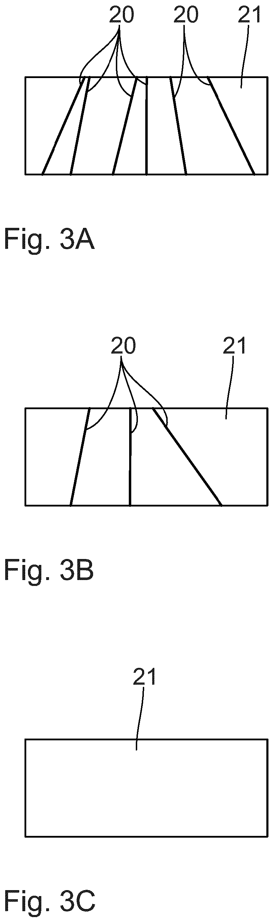

In fig. 3A to fig. 3C, the formation of diffusion channels 20 in a stoichiometric SiC powder 21 of different density is shown:
- In fig. 3A, the stoichiometric SiC powder 21 has a rather low density, in particular tap density, for example below approximately 1.5 g/cm³. Therefore, a high number of diffusion channels 20 is formed, creating a high flux of gas species at rather low growth temperatures. This results in a silicon-rich SiC growth gas phase 9.
- In fig. 3B, the stoichiometric SiC powder 21 has a medium density, in particular tap density, for example between 1.5 g/cm³ and 1.8 g/cm³. In comparison with a stoichiometric SiC powder 21 having a low powder density, the number of diffusion channels 21 is reduced, which leads to an increase in growth temperature at which significant material transport from the SiC powder 21 will take place. Therefore, the SiC growth gas phase 9 will be enriched in carbon in comparison to the situation of fig. 3A.
- In fig. 3C, the stoichiometric SiC powder 21 has a high density, in particular tap density, for example above 1.8 g/cm³. Therefore, there are very few, in particular no, diffusion channels 20, allowing for material transport from within the bulk powder. As such, the sublimation process only takes place close to the surface of the stoichiometric SiC powder 21 so that high growth temperatures are necessary for material transport.

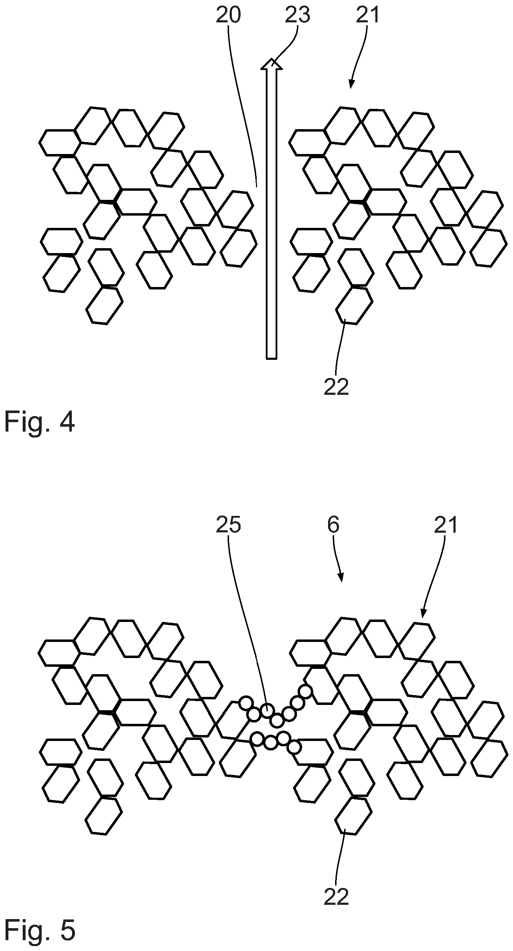

Fig. 4 schematically shows a more detailed view of a diffusion channel 20 in a stoichiometric SiC powder 21. The stoichiometric SiC powder 21 consists of SiC particles 22. A diffusion channel 20 is formed between the SiC particles 22, which allows for transport of gas species from the bulk powder along a transport direction indicated by the arrow 23.

From the above description, it is clear that the number of diffusion channels and with that the transport of gas species from the bulk powder essentially depends on the density of the stoichiometric SiC powder 21. Hence, the composition of the SiC growth gas phase 9 at a given growth temperature depends on the density of the stoichiometric SiC powder 21. At the same time, the growth temperature and the temperature gradient determine the growth conditions, in particular the material transport of the gas species to and within the SiC growth gas phase 9. In consequence, using a stoichiometric SiC powder 21 does not allow controlling independently the volume of sublimated gas species, their transport as well as their composition. This leads to the effect that the conditions at the growth interface 16 and the sublimation of stoichiometric SiC powder are not matched ideally for the crystal growth, which may lead to the formation of dislocations and other defects.

To overcome these drawbacks, the SiC source material 6 inserted in the SiC storage region 4 comprises an excessive carbon content, which exceeds the stoichiometric ratio of SiC. The SiC source material 6 is a non-stoichiometric source material. The ratio of carbon atoms to silicon atoms in the SiC source material 6 is at least 1.01:1, in particular at least 1.05:1, in particular at least 1.1:1, preferably at least 1.2:1. The ratio may be between 1.01:1 and 1.5:1, in particular between 1:05:1 and 1:4:1, in particular between 1.1:1 and 1.3:1, preferably between 1.2:1 and 1.3:1. The SiC source material may have a carbon content, which, in relation to the silicon content exceeds the stoichiometric ratio of SiC by at least 1 at%, in particular at least 5 at%, in particular at least 10 at%, preferably at least 20 at%.

The excessive carbon content allows tailoring the formation as well as the permeability of diffusion channels 20. In particular, the excessive carbon content tends to agglomerate the SiC source material 6, in particular by forming carbon agglomerates. These carbon agglomerates connect the SiC particles 22, thereby limiting the formation and/or permeability of diffusion channels 21. Thereby, the transport of gas species from the bulk powder is decreased, in particular in a controllable manner.

The excessive carbon content allows influencing the formation of diffusion channels, thereby influencing the gas transport and the sublimation of SiC source material 6. The SiC growth gas phase 9 can be influenced to best meet the optimal growth condition at the growth interface 16. Thus, the formation of defects is strongly suppressed which leads to a highly improved crystal quality.

Moreover, the excessive carbon content provides a further parameter to control the growth condition, allowing separating the temperature and temperature gradient inside the growth crucible 3 from the transport and composition of the SiC growth gas phase 9. This enables a wider range of possible growth conditions. For example, by adding a high amount of excessive carbon to the SiC source material 6, the formation of diffusion channels 20 will be strongly suppressed, leading to the possibility to use high temperature at the phase boundary without having a too high material transport and/or growth rate. In particular, a higher surface mobility of the atoms and/or molecules in the SiC growth gas phase 9 can be utilized to reach a step-flow growth mode with strongly reduced dislocation formation.

Fig. 5 shows a schematic depiction of an exemplary SiC source material 6. The SiC source material 6 comprises the stoichiometric SiC powder 21 formed of SiC particles 22 and an excessive carbon content. In the example of fig. 5, the excessive carbon content forms carbon agglomerates 25. The carbon agglomerates 25 act as carbon connectors, connecting SiC particles 22. The carbon agglomerates 25 lead to an agglomeration of the SiC source material 6, thereby reducing the formation and/or permeability of diffusion channels 20, in particular closing diffusion channels 20.

Due to the carbon agglomerates 25, the SiC source material 6 may be a SiC source material body in the form of a powder compact.

The SiC source material 6 has a tap density between 1 g/cm³ and 2.5 g/cm³, in particular between 1.2 g/cm³ and 1.9 g/cm³, preferably between 1.5 g/cm³ and 1.8 g/cm³.

The carbon agglomerates 25 shown in fig. 5 may be formed during the heating up of the growth crucible 3 before sublimation starts. It is also possible to perform an agglomeration process on the SiC source material 6 before the SiC source material 6 is inserted in the growth crucible.

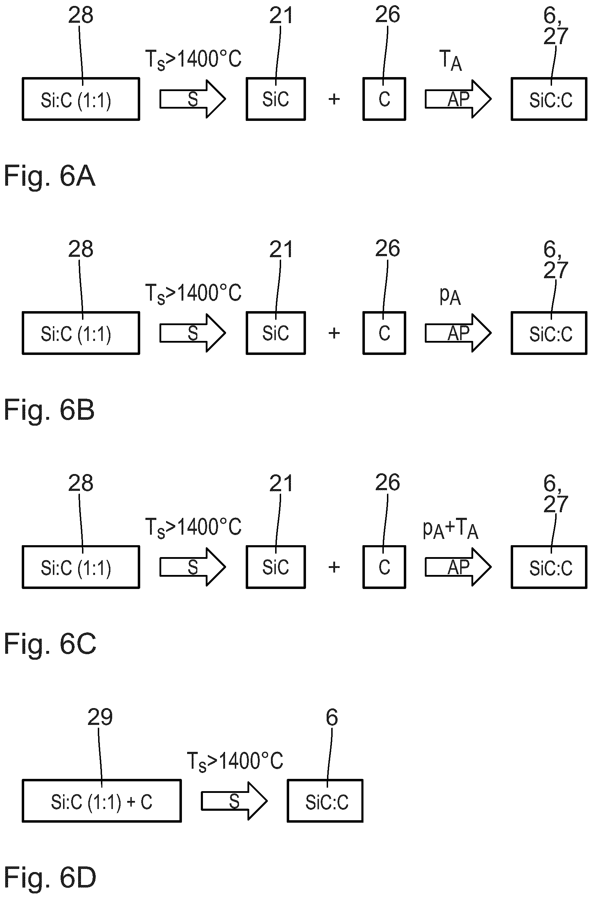

With regard to fig. 6A to 6D, different preparation methods for preparing the SiC source material 6 having an excessive carbon content are described.

In fig. 6A, a stoichiometric SiC powder 21 is mixed with a carbon-containing additive 26. The SiC powder 21 has a stoichiometric ratio of carbon and silicon atoms and is denoted as SiC. The carbon-containing additive 26 adds additional carbon atoms (C) to the powder mixture. Preferably, the carbon-containing additive 26 contains or consists of carbon. It may comprise further constituents, in particular volatile constituents, such as hydrogen, oxygen, water molecules and the like.

For example, the carbon-containing additive 26 may comprise carbon particles, such as crystalline or amorphous carbon particles, for example natural or synthesized graphite particles and/or black amorphous carbon particles.

Additionally or alternatively, the carbon-containing additive 26 may comprise a carbon compound. For example, the carbon compound is a carbon glue, for example based on cyanoacrylate and/or one or more phenolic resins, in particular one or more novolaks.

Particularly suitable carbon compounds are carbohydrates, in particular a sugar. The sugar may be a monosaccharide, a disaccharide or any other sugar. All the other kinds of carbohydrates or combinations thereof are also possible. For example, the carbon-containing additive 26 may comprise, in particular may consist of, an aqueous carbohydrate solution, in particular an aqueous sugar solution.

After mixing the SiC powder 21 with the carbon-containing additive 26, the powder mixture undergoes an agglomeration process AP to form a SiC source material body 27. In the example of fig. 6A, the agglomeration process AP comprises a temperature treatment at an agglomeration temperature T_{A}, being in the range from 100 °C to 2,500 °C, in particular between 100 °C and 1,000 °C, in particular between 150 °C and 700 °C, preferably between 200 °C and 600 °C. In the agglomeration process AP, the carbon-containing additive 26, in particular the carbon content thereof, forms carbon agglomerates, which lead to an agglomeration of the powder mixture to form the SiC source material 6 in form of the SiC source material body 27. The SiC source material 6, in particular the SiC source material body 27, are also denoted by SiC:C.

The SiC source material 6 in form of the SiC source material body 27 is then inserted into the growing crucible 3.

Performing the agglomeration process AP prior to inserting the SiC source material 6 into the crucible has the particular advantage that further constituents of the carbon-containing additive 26 may be removed from the SiC source material 6. For example, volatile constituents may evaporate during the temperature treatment.

It is also possible to perform the agglomeration process AP in situ in the growing crucible 3, by introducing the mixture of the SiC powder 21 with the carbon-containing additive 26 into the SiC storage region 4 of the growth crucible 3. In that case, the SiC source material 6 is inserted in powdered form in the growth crucible 3. The temperature treatment takes place in situ during heating-up the growth crucible 3 to the growth temperature.

As shown in fig. 6A, the preparation method may optionally also comprise the synthesis S of the stoichiometric SiC powder 21. To this end, a silicon powder particles and a carbon powder particles are mixed in a stoichiometric ratio (being a ratio of the silicon atoms to the carbon atoms of 1:1) to obtain a stoichiometric raw material powder 28, also denoted as Si:C (1:1). The stoichiometric raw material powder 28 is reacted to the SiC powder 21 in a reaction oven at a reaction temperature Ts exceeding 1,400 C°. After the components of the stoichiometric raw material powder 28 have reacted through, the stoichiometric SiC powder 21 results.

The preparation procedure shown in fig. 6B coincides mainly with the preparation procedure of fig. 6A. It differs in the agglomeration process AP, which comprises a pressure treatment exerting an agglomeration pressure p_{A} on the mixture of the SiC powder 21 with the carbon-containing additive 26. The agglomeration pressure p_{A} is between 3 bar and 200 bar, in particular between 10 bar and 150 bar. For example, the agglomeration pressure p_{A} may be exerted mechanically on the powder mixture, for example by a mechanical press.

In the example of fig. 6C, the agglomeration process AP comprises a temperature treatment and a pressure treatment. The temperature treatment and the pressure treatment may be performed simultaneously or sequentially. In particular, the pressure treatment may be followed by the temperature treatment. For example, the powder mixture of SiC powder 21 and carbon-containing additive may first be pressed to form a powder mixture compact. The powder mixture compact can then undergo the temperature treatment.

The preparation process of fig. 6D differs from the preparation processes in figs. 6A to 6C in that the excessive carbon content is not added to a SiC powder 21 after the synthesis process, but prior to the synthesis process. In that regard, a mixture of silicon powder and carbon powder is prepared, wherein an excessive carbon content is added. The resulting mixture is a non-stoichiometric raw material powder 29 comprising a carbon content, which exceeds the stoichiometric ratio of SiC. The non-stoichiometric raw material powder 29 may also be denoted as Si:C (1:1) + C. The non-stoichiometric raw material powder is reacted in a reaction oven at a reaction temperature Tₛ to synthesize a non-stoichiometric SiC source material 6 (SiC:C). The reaction temperature T_{S} is between 1,000 °C and 2,500 °C, in particular between 1,100 °C and 2,100 °C, preferably between 1,200 °C and 2,000 °C. In the variant of fig. 6D, the SiC source material 6 may be obtained directly in a synthesis process for synthesizing SiC. The SiC source material 6 obtained in the synthesis process may be in a powdered form. It is also possible to agglomerate the excessive carbon content during synthesis process S, thereby forming carbon agglomerates.

It is also possible to combine one or more of the preparation processes in figs. 6A to 6D. For example, a non-stoichiometric SiC source material 6 obtained in a synthesis process may be mixed with a carbon-containing additive 26 and undergo a separate agglomeration process AP. It is also possible to perform an agglomeration process AP on a non-stoichiometric SiC source material 6, which is obtained in a synthesis process as described with respect to fig. 6D and which may be in powdered form.

## Claims

1. A method for the production of at least one SiC volume monocrystal (2) by means of sublimation growth, wherein,
a) prior to the start of growth,
a1) at least one SiC seed crystal (8) is arranged in a crystal growth region (5) of a growing crucible (3), and
a2) SiC source material (6) is provided and inserted into an SiC storage region (4) of the growing crucible (3), and,
b) during the growth by means of sublimation of the SiC source material (6) and by means of transport of the sublimated gaseous components into the crystal growth region (5), a SiC growth gas phase (9) is produced in the crystal growth region (5), in which a SiC volume monocrystal (1) grows on the SiC seed crystal (8) by means of deposition from the SiC growth gas phase (9),
**characterized in that**
c) in the provided SiC source material (6), a ratio of carbon atoms to silicon atoms is at least 1.01:1, in particular at least 1.05:1.

2. The method according to claim 1, **characterized in that** the ratio of carbon atoms to silicon atoms in the provided SiC source material (6) is 1.5:1 or less, in particular 1.4:1 or less, preferably 1.3:1 or less.

3. The method according to claim 1 or 2, **characterized in that** the provided SiC source material (6) has a density between 1 g/cm³ and 2.5 g/cm³, in particular between 1.2 g/cm³ and 1.9 g/cm³, preferably between 1.5 g/cm³ and 1.8 g/cm³.

4. The method according to any one of the preceding claims, **characterized in that** the provided SiC source material (5) comprises, in particular consists of, a SiC powder (21) and a carbon-containing additive (26).

5. The method according to claim 4, **characterized in that** the carbon-containing additive (26) comprises carbon particles and/or one or more carbon compounds.

6. The method according to claim 4 or 5, **characterized in that** the carbon-containing additive (26) comprises a carbon compound being a carbon glue and/or a carbohydrate, in particular a sugar.

7. The method according to any one of the preceding claims, **characterized in that** providing the SiC source material (6) comprises mixing silicon powder particles with carbon powder particles to obtain a powdered raw material, wherein the carbon content in the powdered raw material exceeds the stoichiometric ratio of SiC, in particular **in that** a ratio of carbon atoms to silicon atoms is at least 1.01:1, and reacting the powdered raw material in a reaction oven to synthesize non-stoichiometric SiC source material (6).

8. Method according to any one of preceding claims, **characterized in that** the SiC source material (6) is inserted in powdered form into the SiC storage region (4), wherein a carbon content of the SiC source material (6), which exceeds the stoichiometric ratio of SiC, forms carbon agglomerates (25) during heating up the crucible (3) before growth starts.

9. The method according to any one claims 1 to 7, **characterized in that** providing the SiC source material (6) comprises forming a SiC source material body (27), which contains carbon agglomerates (25) and which is inserted into the SiC storage region (4).

10. The method according to claim 9, **characterized in that** forming the SiC source material body (27) comprises mixing a SiC powder (21) with a carbon-containing additive (26) to obtain a powder mixture and performing an agglomeration process (AP) on the powder mixture.

11. The method according to claim 9 or 10, **characterized in that** the agglomeration process (AP) includes a temperature treatment of the powder mixture at an agglomeration temperature (T_{A}) between 100 °C and 2500 °C, in particular between 100 °C and 1000 °C, in particular between 150 °C and 700 °C, preferably between 200 °C and 600 °C.

12. The method according to any one of claims 9 to 11, **characterized in that** the agglomeration process (AP) includes a pressure treatment of the powder mixture, in particular at an agglomeration pressure (p_{A}) between 3 bar and 200 bar, in particular between 10 bar and 150 bar.

13. A SiC source material (6) to be used in a method for the production of at least one SiC volume monocrystal by means of sublimation growth, **characterized by** a ratio of carbon atoms to silicon atoms is at least 1.01:1, in particular at least 1.05:1.

14. The SiC source material (6) according to claim 13, **characterized in that** the SiC source material comprises, in particular consists of, a SiC powder (21) and a carbon-containing additive (26).

15. The SiC source material according to claim 13 or 14, **characterized in that** the SiC source material (6) is in form of a SiC source material body (27) comprising carbon agglomerates (25).
